(19) **Europäisches Patentamt European Patent Office Office européen des brevets**

(11) **EP 2 323 255 B1**

(12) **FASCICULE DE BREVET EUROPEEN**

(45) Date de publication et mention
de la délivrance du brevet:
**19.03.2014 Bulletin 2014/12**

(51) Int Cl.:
*H03F 1/30* (2006.01)        *H03F 3/191* (2006.01)
*H03F 3/30* (2006.01)

(21) Numéro de dépôt: **10190278.1**

(22) Date de dépôt: **05.11.2010**

(54) **Circuit d'amplification de puissance d'un signal d'entrée et système d'émission incorporant un tel circuit**

Leistungsverstärkerschaltung für ein Eingangssignal und Übertragungssystem mit einer solchen Schaltung

Power amplifier circuit for an input signal and transmission system including such a circuit

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.11.2009 FR 0905399**

(43) Date de publication de la demande:
**18.05.2011 Bulletin 2011/20**

(73) Titulaire: **Thales**
**92200 Neuilly Sur Seine (FR)**

(72) Inventeurs:
• **Petit, Vincent**
**78550 Bazainville (FR)**

• **Louis, Bruno**
**94100 Saint Maur (FR)**
• **Corbière, Rémi**
**78990 Elancourt (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**US-A- 5 986 509          US-A1- 2004 000 954**
**US-A1- 2008 079 496**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention porte sur un circuit d'amplification de puissance, en particulier réalisé sur silicium et apte à traiter des signaux dont la fréquence est comprise dans la bande X (classiquement, entre 8 et 12 GHz).

Ces circuits peuvent être par exemple utilisés dans des modules actifs d'émission/réception, tel que ceux intégrés au sein des radars. Plus précisément, ces modules comprennent des puces aptes à déphaser et atténuer ou amplifier le signal reçu ou à émettre. La fonction d'amplification est réalisée par le circuit d'amplification qui idéalement doit être capable de fournir la puissance nécessaire requise tout en garantissant une bonne linéarité de la chaîne d'émission/réception.

Un circuit d'amplification idéal doit notamment :

- fournir le niveau puissance requis en sortie,
- perturber le moins possible les autres circuits couplés en amont,
- être suffisamment linéaire pour les applications visées, et
- permettre le contrôle du gain de sortie,

tout cela avec une consommation de puissance la plus faible possible.

Le circuit d'amplification est notamment défini par son impédance d'entrée, son gain et sa fréquence de transition.

De façon que le fonctionnement du circuit soit optimal, il est préférable de se placer dans sa zone de fonctionnement linéaire, de façon à bénéficier de valeurs maximales et contrôlées du gain d'amplification.

Cette zone de fonctionnement linaire est formée par les fréquences comprises entre 0 et la fréquence de transition Ft. Cette dernière est définie par :

où :

- *Ft* est la fréquence de transition,
- *Fc* la fréquence de coupure, et
- *Gmax,* la valeur maximale pouvant être prise par le gain en courant du circuit d'amplification.

Pour pouvoir délivrer de sortie maximale, il est nécessaire de se placer à des valeurs de fréquence pour lesquelles le gain prend sa valeur maximale, c'est-à-dire dans la zone de fonctionnement linéaire du circuit.

Or jusque lors, dans les circuits d'amplification, le fait de travailler à des valeurs de gain élevées implique une impédance d'entrée faible, notamment lié à l'utilisation d'un transistor autopolarisé par une source de courant, (par exemple un miroir de courant) et monté en émetteur commun.

Un exemple d'amplificateur en émetteur commun peut être trouvé dans le document de brevet US 2004/0000954.

Dans cette configuration (pour des transistors de dimensions judicieusement choisies), l'impédance d'entrée s'exprime sous la forme :

$$Ze = \frac{\beta}{2gm}, \qquad\qquad (1)$$

où :

- Ze est l'impédance d'entrée du circuit d'amplification, et
- β est le gain du transistor autopolarisé.

Une impédance d'entrée faible a pour désavantage :

- d'être néfaste au couplage avec un autre circuit disposé en amont, et
- de diminuer la valeur de la fréquence de transition, et par conséquent de réduire l'étendue de la zone de fonctionnement linaire du circuit d'amplification.

Un but de l'invention est notamment de résoudre ces problèmes.

A cet effet, selon un premier aspect de l'invention, il est proposé un circuit d'amplification de puissance d'un signal d'entrée comprenant un étage d'entrée et un étage de sortie, ledit étage d'entrée comportant :

- un moyen de pilotage incorporant un transistor de pilotage dit principal, et
- un premier transistor d'entrée dit principal apte à recevoir le signal d'entrée, et monté en miroir de courant avec le transistor de pilotage principal.

Selon un caractéristique générale de cet aspect, le premier transistor d'entrée principal est couplé à l'étage de sortie via un deuxième transistor d'entrée dit principal, incorporé à l'étage d'entrée et commandé par le moyen de pilotage, les premier et deuxième transistors d'entrée principaux étant couplés entre eux et avec la masse selon une structure de type Darlington par l'intermédiaire d'un circuit résonnant.

En d'autres termes, tout en conservant la fonction amplificatrice du circuit, la structure du transistor auto-polarisé est notamment remplacée par une structure de type Darlington.

L'invention permet ainsi d'augmenter la valeur de l'impédance d'entrée du circuit, et par voie de conséquence, celle de la fréquence de transition. La plage de fonctionnement linaire en est ainsi accrue.

Par ailleurs, de par l'utilisation d'un circuit résonnant pour le couplage des premier et deuxième transistors principaux, le circuit d'amplification est apte à traiter des signaux dont la fréquence est comprise dans la bande X.

Selon un mode de réalisation, le premier et le deuxième transistor d'entrée principal peuvent être configurés de façon à être traversés par des courants d'amplitude équivalente, à une erreur près.

Par exemple ledit signal d'entrée peut être de type simple, ledit deuxième transistor principal étant alors commandé par le transistor de pilotage principal.

En variante, ledit signal d'entrée est de type différentiel, l'étage d'entrée comprenant alors en outre :

- un transistor de pilotage dit auxiliaire, incorporé au sein dudit moyen de pilotage,
- un premier transistor d'entrée dit auxiliaire, et
- un deuxième transistor d'entrée dit auxiliaire,

chaque élément dit auxiliaire étant monté symétriquement à l'élément correspondant dit principal.

Selon un mode de réalisation, le deuxième transistor d'entrée principal peut être commandé par le transistor de pilotage principal, et le deuxième transistor d'entrée auxiliaire être commandé par le transistor de pilotage auxiliaire.

En variante, le deuxième transistor d'entrée principal peut être commandé par le transistor de pilotage auxiliaire, et le deuxième transistor d'entrée auxiliaire être commandé par le transistor de pilotage principal.

De préférence, le premier et le deuxième transistor d'entrée auxiliaires peuvent être configurés de façon à être traversés par des courants d'amplitude équivalente, à une erreur près.

Selon un mode de réalisation, le circuit peut être réalisé en outre sur silicium.

Selon un autre aspect de l'invention, il est proposé un système d'émission/transmission d'un signal, incorporant un circuit tel que mentionné ci-avant.

Selon un autre aspect de l'invention, il est proposé une utilisation d'un système d'émission/transmission d'un signal mentionné ci-dessus, au sein d'un radar.

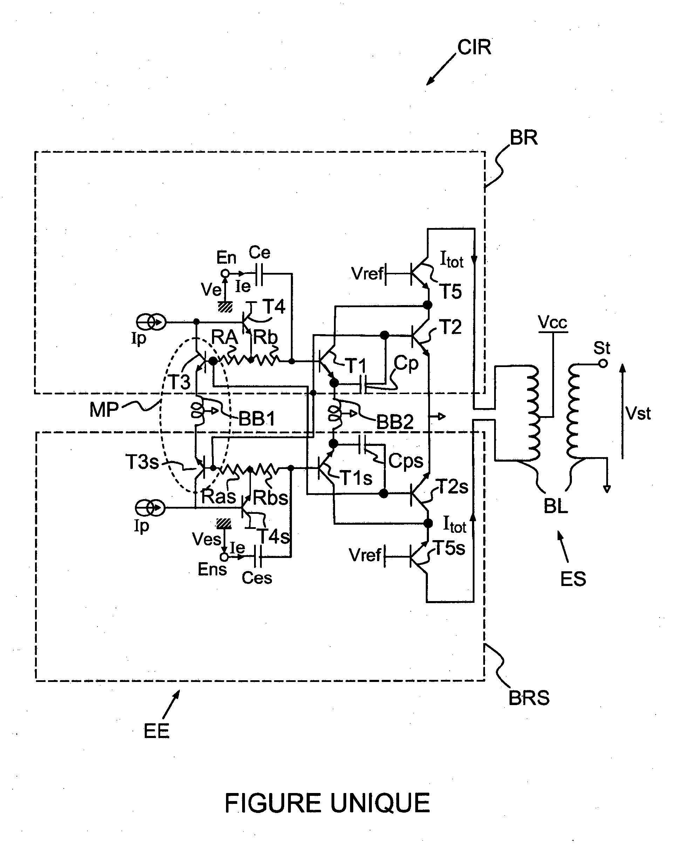

D'autres avantages et caractéristiques de l'invention apparaîtront à l'examen de la description détaillée d'un mode de réalisation selon l'invention, nullement limitatif, et d'une figure unique annexée sur laquelle est représenté un exemple de circuit d'amplification selon l'invention.

On se réfère à présent à la figure unique. La référence CIR désigne un circuit d'amplification.

Celui-ci comprend un étage d'entrée EE couplé à un étage de sortie ES.

L'étage d'entrée est ici formé de deux branches symétriques BR et BRS couplées entre-elles via deux bobines BB1 et BB2, comme décrit plus en détail ci-après.

Le circuit CIR comporte deux branches BR et BRS car l'on considère un signal d'entrée de type différentiel. Dans le cas d'un signal d'entrée de type simple, le circuit CIR ne serait naturellement formé que d'une seule des deux branches.

La branche BR va être décrite de manière détaillée. A chaque élément dit principal de la banche BR correspond un élément dit auxiliaire symétrique au sein de la branche BRS. Les références de ces éléments auxiliaires comportent un suffixe « s », comme représenté sur la figure. De façon à simplifier la description, seule la branche BR va être décrite, la branche BRS lui étant similaire.

Un courant de polarisation Ip est délivré en entrée de l'étage d'entrée EE, à la fois sur la branche BR et sur la branche BRS, étant donné que l'on considère un signal d'entrée de type différentiel.

Le signal d'entrée différentiel est appliqué sous forme d'une tension différentielle VeVes, respectivement sur les bornes d'entrée En et Ens des branches BR et BRS du circuit CIR. Plus précisément, la tension différentielle d'entrée est appliquée sur la base respective d'un premier transistor principal T1 et d'un premier transistor auxiliaire, T1 s par l'intermédiaire de deux condensateurs référencés Cp et Cps.

Le courant de polarisation Ip est délivré en entrée d'un transistor principal de polarisation T3, plus précisément sur son collecteur.

Le transistor principal de polarisation T3 est monté en miroir de courant avec le premier transistor principal T1. En d'autres termes, la base du transistor principal de polarisation T3 est reliée à la base du premier transistor principal T1, ici par l'intermédiaire de deux résistances Ra et Rb montées en série. Leur valeur respective peut être de l'ordre d'une centaine d'ohms.

De façon à limiter les pertes du courant de pilotage transmis par le transistor principal de polarisation T3, un transistor T4 est également connectée entre la source de courant délivrant le courant de polarisation Ip et le noeud commun aux deux résistances Ra et Rb.

Ce transistor fournit un courant supplémentaire dit de base, dont la valeur correspond à la valeur du courant dissipé par le transistor principal de polarisation T3.

L'émetteur du transistor principal de polarisation T3 est relié par l'intermédiaire d'une bobine BB1 à l'émetteur du transistor auxiliaire de polarisation T3s. Les deux transistors T3 et T3s forment un moyen de pilotage MP.

De même, L'émetteur du premier transistor principal d'entrée T1 est relié par l'intermédiaire d'une bobine BB2 à l'émetteur du premier transistor auxiliaire d'entrée T1 s.

Ces bobines BB1 et BB2 permettent de découpler les transistors T3, T3s, T1 et T1s de la masse, en créant une haute impédance à la fréquence de travail.

Par ailleurs, la bobine BB2 forme un circuit résonnant de type LC avec le condensateur Cp, ce circuit résonnant couplant les transistors T1 et T2 entre eux et avec la masse symbolisée par une flèche blanche. Ce circuit résonnant permet au circuit d'amplification de pouvoir traiter des signaux dont la fréquence est comprise dans la bande X.

Plus précisément, le premier transistor principal d'entrée T1 est monté selon une structure de type Darlington bien connue de l'homme du métier avec un deuxième transistor principal d'entrée T2. Autrement dit, le collecteur du deuxième transistor principal d'entrée T2 est couplé au collecteur du premier transistor principal d'entrée T1. Par ailleurs, la base du deuxième transistor principal d'entrée T2 est couplée à l'émetteur du premier transistor principal d'entrée T1 via un condensateur Cp.

Les premier et deuxième transistors d'entrée principaux sont configurés de façon qu'ils soient traversés par des courants de valeurs similaires, à une erreur près.

Plus précisément, on a (pour la branche BR) :

$$Ze = \frac{Ve}{Ie},$$

où

- Ze est l'impédance d'entrée de la branche BR du circuit d'amplification,
- Ve la tension d'entrée, et
- Ie le courant d'entrée.

Or:

$$Ve = Vbe1 + Vbe2,$$

où

- Vbe1 est la tension base/émetteur du transistor T1, et
- Vbe2 est la tension base/émetteur du transistor T2.

A des fins de simplification, on considère que Vbe1=Vbe2. Il vient :

$$Ve = 2*Vbe2.$$

Par conséquent, on obtient :

$$Ze = \frac{2Vbe}{Ib} = \frac{2Vbe}{\dfrac{Ic}{\beta}} = \frac{2Vbe}{gmVbe} * \beta = \frac{2\beta}{gm}, \qquad (2)$$

où :

- *Ib* est le courant de base du transistor T1 (ou T2),
- *Ic* est le courant de collecteur du transistor T1 (ou T2),
- *gm* est la valeur de la transconductance du transistor T1 (ou T2), et
- $\beta$ est le gain du transistor T2 (ou T1).

L'impédance d'entrée selon l'invention (équation (2)) est ainsi largement supérieure à l'impédance d'entrée des circuits selon l'art antérieur (voir équation (1) ci-avant), améliorant le couplage avec un éventuel circuit couplé en amont.

Par conséquent, le gain en courant G de la branche BR du circuit CIR peut s'écrire :

$$G = \frac{Itot}{Ie} = \frac{2 * gm * \dfrac{Ve}{2}}{\dfrac{Ve}{Ze}} = Ze * gm,$$

où :

- *G* est le gain en courant du circuit CIR,
- *Itot* est le courant total délivré en sortie de la branche BR du circuit CIR,
- Ie est le courant d'entrée de la branche BR du circuit,
- *gm* est la valeur de la transconductance du transistor T1 (ou T2).

Ainsi, l'augmentation de la valeur de l'impédance d'entrée Ze implique une augmentation de la valeur de gain en courant G du circuit.

Comme :

$$Ft = \frac{jG}{2},$$

avec *Ft*, la fréquence de transition, l'augmentation du gain en courant G implique bien une augmentation de la valeur de la fréquence de transition.

Le même calcul s'applique à la branche BRS du circuit CIR.

Ainsi, l'étendue de la zone de fonctionnement linéaire du circuit CIR se trouve largement accrue. En conséquence, il est possible de bénéficier de la valeur maximale du gain du circuit pour une plus large gamme de fréquences.

Comme illustré sur la figure, la base du deuxième transistor principal d'entrée T2 est reliée à la base du transistor auxiliaire de polarisation T3s.

Ainsi, le transistor est piloté en mode dynamique par le premier transistor principal d'entrée T1. En mode statique, le deuxième transistor principal d'entrée T2 est polarisé par le transistor principal de polarisation T3s.

En variante, la base du deuxième transistor principal d'entrée T2 peut être reliée à la base du transistor de polarisation principal T3 et la base du deuxième transistor auxiliaire d'entrée T2s reliée à la base du transistor de polarisation auxiliaire T3 (comme illustré sur la figure). Le croisement illustré sur la figure permet de répercuter les variations d'une branche au sein de l'autre branche et ainsi de conserver un signal différentiel parfaitement symétrique.

Par ailleurs, le deuxième transistor principal d'entrée T2 est monté en cascode avec un transistor T5. L'émetteur du deuxième transistor principal d'entrée T2 est relié à la masse et son collecteur est couplé à l'émetteur du transistor T5. La base de l'émetteur T5 est reliée à une borne de tension de référence Vref.

Le transistor T5 forme un tampon entre l'étage d'entrée EE et l'étage de sortie ES en :

- imposant une tension sur le collecteur du deuxième transistor principal d'entrée T2,
- en limitant l'impédance sur le collecteur du deuxième transistor principal d'entrée T2, et
- en limitant l'effet Miller du circuit, c'est-à-dire, l'influence du propre gain du circuit d'amplification sur des caractéristiques d'entrée, en particulier, la réduction de l'impédance d'entrée.

Le collecteur du transistor T5 est couplé à l'étage de sortie ES. Ce dernier comprend pour ce mode différentiel un balun BL c'est-à-dire un circuit électrique apte à effectuer la liaison entre des lignes imprimées parallèles et une ligne imprimée au dessus d'un plan de masse.

Le balun BL est alimenté par une tension d'alimentation Vcc, et la tension de sortie entre une borne de sortie St du circuit CIR et la masse est référencé St.

La tension d'alimentation Vcc est également utilisée pour alimenter l'ensemble des éléments actifs du circuit CIR. Les connexions ne sont pas représentées pour des raisons de simplification.

Le circuit d'amplification CIR selon l'invention a également pour avantage d'être particulièrement compact. En effet, le transistor T3 (ou T3s selon la configuration choisie) participant directement à la polarisation statique du transistor T2 (ou T2s), il est particulièrement avantageux de la placer à proximité des transistors T2 (ou T2s). Il en résulte un circuit peu encombrant.

Les transistors utilisés dans cet exemple sont de type bipolaire sur substrat de silicium. Il est aussi possible d'utiliser des transistors bipolaires sur substrat de type AsGa ou InP.

## Revendications

1. Circuit (CIR) d'amplification de puissance d'un signal d'entrée comprenant un étage d'entrée (EE) et un étage de sortie (ES), ledit étage d'entrée (EE) comportant :

   - un moyen de pilotage (MP) incorporant un transistor de pilotage dit principal (T3), et
   - un premier transistor d'entrée dit principal (T1) apte à recevoir le signal d'entrée, et monté en miroir de courant avec le transistor de pilotage principal (T3),
   **caractérisé par le fait que** le premier transistor d'entrée principal (T1) est couplé à l'étage de sortie (ES) via un deuxième transistor d'entrée dit principal (T2), incorporé à l'étage d'entrée (EE) et commandé par le moyen de pilotage (MP), les premier (T1) et deuxième (T2) transistors d'entrée principaux étant couplés entre eux et avec la masse selon une structure de type Darlington par l'intermédiaire d'un circuit résonnant (BB2, Cp).

2. Circuit selon la revendication 1, dans lequel le premier (T1) et le deuxième (T2) transistor d'entrée principal sont configurés de façon à être traversés par des courants d'amplitude équivalente, à une erreur près.

3. Circuit selon l'une des revendications 1 ou 2, dans lequel ledit signal d'entrée est de type simple, ledit deuxième transistor principal étant commandé par le transistor de pilotage principal (T3).

4. Circuit selon l'une des revendications 1 ou 2, dans lequel ledit signal d'entrée est de type différentiel, et dans lequel l'étage d'entrée (EE) comprend en outre :

   - un transistor de pilotage dit auxiliaire (T3s), incorporé au sein dudit moyen de pilotage (MP),
   - un premier transistor d'entrée dit auxiliaire (T1 s), et
   - un deuxième transistor d'entrée dit auxiliaire (T2),
   chaque élément dit auxiliaire étant monté symétriquement à l'élément correspondant dit principal.

5. Circuit selon la revendication 4, dans lequel le deuxième transistor d'entrée principal (T2) est commandé par le transistor de pilotage principal (T3), et le deuxième transistor d'entrée auxiliaire (T2s) est commandé par le transistor de pilotage auxiliaire.

6. Circuit selon la revendication 4, dans lequel le deuxième transistor d'entrée principal (T2) est commandé par le transistor de pilotage auxiliaire (T3s), et le deuxième transistor d'entrée auxiliaire (T2s) est commandé par le transistor de pilotage principal(T3).

7. Circuit selon l'une des revendications 4 à 6, dans lequel le premier (T1s) et le deuxième (T2s) transistor d'entrée auxiliaires sont configurés de façon à être traversés par des courants d'amplitude équivalente, à une erreur près.

8. Circuit selon l'une des revendications précédentes, réalisé en outre sur silicium.

9. Système d'émission/transmission d'un signal, **caractérisé par le fait qu'**il incorpore un circuit selon l'une des revendications 1 à 8.

10. Utilisation d'un système d'émission/transmission d'un signal selon la revendication 9, au sein d'un radar.

**Patentansprüche**

1. Leistungsverstärkerschaltung (CIR) eines Eingangssignals, die eine Eingangsstufe (EE) und eine Ausgangsstufe (ES) umfasst, wobei die Eingangsstufe (EE) Folgendes umfasst:

   - ein Steuermittel (MP) mit einem Hauptsteuertransistor (T3), und
   - einen ersten Haupteingangstransistor (T1) zum Empfangen des Eingangssignals, der als Stromspiegel mit dem Hauptsteuertransistor (T3) geschaltet ist,
   **dadurch gekennzeichnet, dass** der erste Haupteingangstransistor (T1) mit der Ausgangsstufe (ES) über einen zweiten Haupteingangstransistor (T2) gekoppelt ist, der in die Eingangsstufe (EE) integriert ist und von dem Steuermittel (MP) gesteuert wird, wobei der erste (T1) und der zweite (T2) Haupteingangstransistor miteinander und mit Masse gemäß einer Darlington-Struktur über eine Resonanzschaltung (BB2, Cp) gekoppelt sind.

2. Schaltung nach Anspruch 1, bei der der erste (T1) und der zweite (T2) Haupteingangstransistor so konfiguriert sind, dass sie von Strömen mit äquivalenter Amplitude bis auf einen Fehler durchflossen werden.

3. Schaltung nach Anspruch 1 oder 2, bei der das Eingangssignal von einem einfachen Typ ist, wobei der zweite Haupttransistor vom Hauptsteuertransistor (T3) gesteuert wird.

4. Schaltung nach Anspruch 1 oder 2, bei der das Eingangssignal vom Differentialtyp ist und bei der die Eingangsstufe (EE) ferner Folgendes umfasst:

   - einen Zusatzsteuertransistor (T3s), der im Innern des Steuermittels (MP) integriert ist,
   - einen ersten Zusatzeingangstransistor (T1s), und
   - einen zweiten Zusatzeingangstransistor (T2),
   wobei jedes Zusatzelement symmetrisch zu dem entsprechenden Hauptelement montiert ist.

5. Schaltung nach Anspruch 4, bei der der zweite Haupteingangstransistor (T2) vom Hauptsteuertransistor (T3) gesteuert wird und der zweite Zusatzeingangstransistor (T2s) vom Zusatzsteuertransistor gesteuert wird.

6. Schaltung nach Anspruch 4, bei der der zweite Haupteingangstransistor (T2) vom Zusatzsteuertransistor (T3s) gesteuert wird und der zweite Zusatzeingangstransistor (T2s) vom Hauptsteuertransistor (T3) gesteuert wird.

7. Schaltung nach einem der Ansprüche 4 bis 6, bei der der erste (T1s) und der zweite (T2s) Zusatzeingangstransistor so konfiguriert sind, dass sie von Strömen mit äquivalenter Amplitude bis auf einen Fehler durchflossen werden.

8. Schaltung nach einem der vorherigen Ansprüche, die ferner auf Silicium realisiert ist.

9. System zum Ausstrahlen/Senden eines Signals, **dadurch gekennzeichnet, dass** es eine Schaltung nach einem der Ansprüche 1 bis 8 umfasst.

10. Verwendung eines Systems zum Ausstrahlen/Senden eines Signals nach Anspruch 9 im Innern eines Radars.

**Claims**

1. Circuit (CIR) for power amplification of an input signal comprising an input stage (EE) and an output stage (ES), the said input stage (EE) comprising:

   - a drive means (MP) incorporating a so-called main drive transistor (T3), and

- a first so-called main input transistor (T1) able to receive the input signal, and mounted as a current mirror with the main drive transistor (T3), **characterized by** the fact that the first main input transistor (T1) is coupled to the output stage (ES) via a second so-called main input transistor (T2) incorporated into the input stage (EE) and controlled by the drive means (MP), the first (T1) and second (T2) main input transistors being coupled together and with the earth according to a structure of Darlington type by way of a resonant circuit (BB2, Cp).

2. Circuit according to Claim 1, in which the first (T1) and the second (T2) main input transistor are configured so as to be traversed by currents of equivalent amplitude, to within an error.

3. Circuit according to one of Claims 1 or 2, in which the said input signal is of simple type, the said second main transistor being controlled by the main drive transistor (T3).

4. Circuit according to one of Claims 1 or 2, in which the said input signal is of differential type, and in which the input stage (EE) furthermore comprises:

    - a so-called auxiliary drive transistor (T3s) incorporated within the said drive means (MP),
    - a first so-called auxiliary input transistor (T1s), and
    - a second so-called auxiliary input transistor (T2),
    each so-called auxiliary element being mounted symmetrically with the corresponding so-called main element.

5. Circuit according to Claim 4, in which the second main input transistor (T2) is controlled by the main drive transistor (T3), and the second auxiliary input transistor (T2s) is controlled by the auxiliary drive transistor.

6. Circuit according to Claim 4, in which the second main input transistor (T2) is controlled by the auxiliary drive transistor (T3s), and the second auxiliary input transistor (T2s) is controlled by the main drive transistor(T3).

7. Circuit according to one of Claims 4 to 6, in which the first (T1s) and the second (T2s) auxiliary input transistor are configured so as to be traversed by currents of equivalent amplitude, to within an error.

8. Circuit according to one of the preceding claims, embodied furthermore on silicon.

9. Signal emission/transmission system, **characterized by** the fact that it incorporates a circuit according to one of Claims 1 to 8.

10. Use of a signal emission/transmission system according to Claim 9, within a radar.

FIGURE UNIQUE

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   US 20040000954 A